# FASCICULE DE BREVET EUROPEEN

(11) **EP 1 863 035 B1**
(45) Date de publication et mention de la délivrance du brevet: **27.07.2011**
(21) Numéro de dépôt: 07007584.1
(22) Date de dépôt: 13.04.2007
(51) Int. Cl.: G11C 16/10

(54) **Mémoire EEPROM ayant une résistance contre le claquage de transistors améliorée**
EEPROM-Speicher mit verbessertem Widerstand gegen Transistordurchbruch
EEPROM memory with an improved resistor against transistors breakdown

(30) Priorité: 29.05.2006 FR 0604703
(43) Date de publication de la demande: 05.12.2007
(73) Titulaire: STMICROELECTRONICS SA, 92120 Montrouge (FR)
(72) Inventeur: La Rosa, Francesco, 13790 Rousset (FR)
(74) Mandataire: Marchand, André

(56) Documents cités:
- EP-A2- 0 484 298
- WO-A-97/19452
- US-A- 6 064 595

## Description

La présente invention concerne les mémoires EEPROM (mémoires effaçables et programmables électriquement) et vise un perfectionnement de ces mémoires permettant d'améliorer le seuil de claquage de transistors en présence d'une haute tension de programmation ou d'effacement.

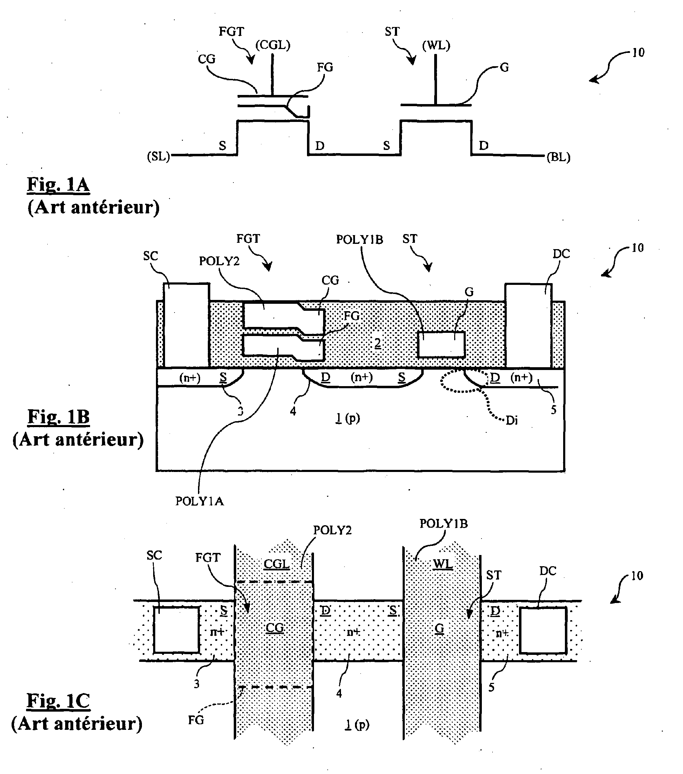

La figure 1A est le schéma électrique d'une cellule mémoire EEPROM classique 10. La cellule mémoire comprend un transistor à grille flottante FGT et un transistor de sélection ST. Le transistor ST comprend une grille G, un drain D (borne de drain) et une source S (borne de source). Le transistor FGT comprend également une grille de contrôle CG, un drain D et une source S, et comprend également une grille flottante FG. La source S du transistor de sélection ST est connectée au drain D du transistor FGT.

La figure 1B est une vue en coupe d'un exemple de réalisation de la cellule mémoire 10 selon la technique à double couche de polysilicium, et la figure 1C montre la cellule mémoire vue de dessus. Trois régions dopées n+ 3, 4, 5 sont formées dans un substrat 1 de type p. La région 3 forme la région de source du transistor FGT, la région 4 forme la région de drain du transistor FGT et la région de source du transistor ST, et la région 5 forme la région de drain du transistor ST. La grille flottante FG du transistor FGT est formée par un pavé de polysilicium POLY1A. La grille G du transistor ST est formée par l'intersection d'une ligne de polysilicium POLY1B avec les régions dopées 4, 5, la ligne POLY1B formant une ligne de mot WL reliant les grilles de divers autres transistors de sélection (non représentés). De même, la grille de contrôle CG du transistor FGT est formée par l'intersection d'une ligne de polysilicium POLY2 avec les régions dopées 3, 4, la ligne POLY2 formant une ligne de contrôle de grille CGL reliant les grilles de contrôle de divers autres transistors FGT (non représentés). Ces diverses parties en polysilicium sont isolées du substrat et isolées les unes relativement aux autres par un diélectrique 2, généralement de l'oxyde de silicium. Enfin, un contact de source SC formé au-dessus de la région 3 relie la source du transistor FGT à une ligne de source SL (non représentée). Un contact de drain DC formé au-dessus de la région 5 relie le drain du transistor ST à une ligne de bit BL (non représentée).

L'enregistrement ou l'effacement d'une donnée dans la cellule mémoire 10 est effectué en injectant des charges électriques dans la grille flottante FG du transistor FGT ou en extrayant des charges électriques de la grille flottante FG. L'injection ou l'extraction de charges modifie la tension de seuil du transistor FGT qui est ensuite détectée par un amplificateur de lecture, dont la fonction est de transformer l'information "tension de seuil" en une donnée binaire, par exemple égale à 1 quand la tension de seuil est négative et égale à 0 quand la tension de seuil est positive.

Les deux processus, d'injection et d'extraction de charges électriques, sont effectués par effet tunnel (effet Fowler-Nordheim). A cet effet, la grille flottante FG présente une région qui s'étend au-dessus de la région de drain 4 et où la couche séparatrice de diélectrique 2 est amincie pour former une fenêtre tunnel TW. Pour programmer la cellule mémoire (injection de charges), une haute tension de programmation est appliquée sur la région de drain du transistor FGT, via le transistor ST, tandis que la grille de contrôle CG est portée à un potentiel nul ou négatif. Pour effacer la cellule mémoire, une haute tension d'effacement est appliquée sur la grille de contrôle CG tandis que la région de source 3 est portée à un potentiel nul ou négatif.

Les performances d'une mémoire EEPROM sont directement liées au temps d'injection ou d'extraction de charges électriques dans les grilles flottantes des cellules mémoire. Une mémoire performante doit présenter un temps de programmation ou d'effacement aussi court que possible. Ce temps dépend de trois paramètres qui interviennent dans le transfert de charges par l'effet tunnel:
1) l'épaisseur du diélectrique formant la fenêtre tunnel TW,
2) la valeur de la haute tension de programmation ou d'effacement,
3) le facteur de couplage grille flottante, soit le rapport entre, d'une part, le couplage capacitif entre la grille flottante et la grille de contrôle et, d'autre part, le couplage capacitif entre la grille flottante, le drain, la source et le substrat.

Or, l'épaisseur du diélectrique tunnel ne peut être réduite en dessous d'un certain seuil, au-delà duquel les cellules mémoire présenteraient des pertes de charges électriques ("retention loss") provoquant à la longue une corruption de données (une mémoire EEPROM étant supposée conserver les données enregistrées pendant plusieurs années). Il s'ensuit que les deux paramètres principaux sur lesquels les performances d'une mémoire EEPROM reposent sont le facteur de couplage et la valeur de la haute tension de programmation ou d'effacement.

Plus le facteur de couplage est grand, plus le processus de programmation ou d'effacement est rapide pour une tension de programmation ou d'effacement déterminée. Toutefois, le facteur de couplage tend à diminuer lorsque la taille des cellules mémoire diminue (rapport W/L longueur sur largueur de grille des transistors FGT et ST). Comme la taille des transistors ne cesse de diminuer avec le perfectionnement des techniques de la microélectronique, on arrive au résultat paradoxal que les mémoires de nouvelle génération, ayant des cellules mémoire de taille plus réduite, nécessitent des tensions de programmation et d'effacement plus élevées que les mémoires de génération précédente. Ainsi, le facteur de couplage représente un obstacle majeur à la diminution de la taille des mémoires EEPROM sans augmentation du temps de programmation ou d'effacement.

En définitive, la solution qui s'impose pour préserver le temps de programmation et d'effacement d'une mémoire EEPROM dont on veut réduire la taille des transistors, est d'augmenter la valeur de la haute tension de programmation ou d'effacement. On se heurte toutefois, là aussi, à une autre contrainte technologique, en ce que les transistors MOS présentent un seuil de claquage ("breakdown") qui détermine la valeur maximale de la tension d'effacement ou de programmation pouvant être appliquée à des cellules mémoire interconnectées.

Sur la figure 1B, la référence Di désigne une région de claquage d'un transistor de sélection ST. Cette région est une jonction PN substrat-drain (et plus particulièrement canal-drain) formant une diode polarisée en inverse. Lorsque la région de drain 5 reçoit une tension de programmation tandis que le substrat 1 est relié à la masse (ce qui, en principe, est toujours le cas), la diode Di atteint son point de claquage (tension de seuil de la diode en inverse) au voisinage d'une valeur qui est de l'ordre de 12V dans les mémoires EEPROM commercialisés par la demanderesse. Ainsi, la tension de programmation ne peut être portée au-delà de cette valeur.

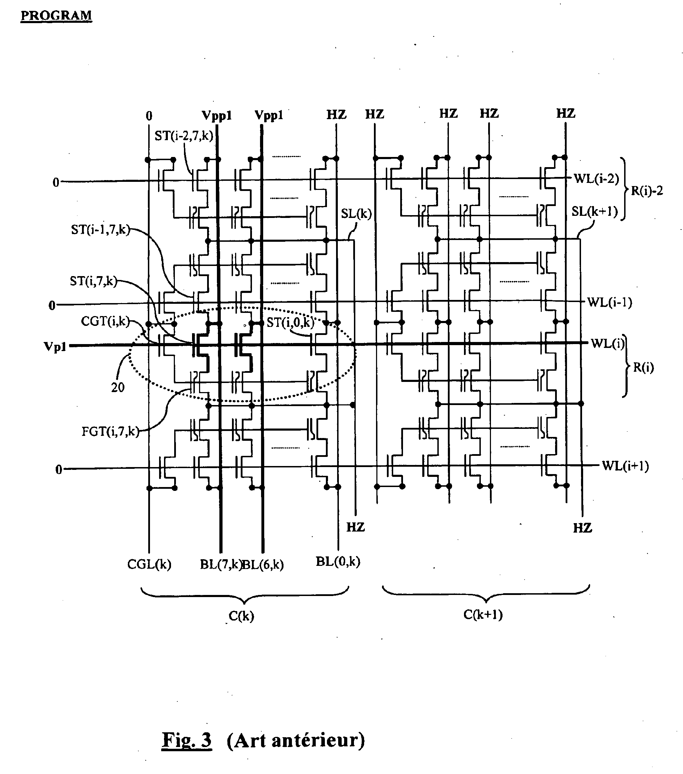

Pour mieux comprendre l'impact du phénomène de claquage sur le processus de programmation et d'effacement, la figure 3 représente une mémoire EEPROM du type effaçable par mot, ayant des cellules mémoire en cours de programmation. Des mémoires de ce type sont décrites par exemple dans EP-1158408, EP-1727152, EP 1172820. On voit que les transistors de sélection ST de cellules mémoire alignées verticalement ont leurs drains respectifs connectés à des lignes de bit communes BL. Par exemple des transistors de sélection ST(i, 7, k) et ST(i-2, 7, k) sont connectés à une même ligne de bit BL(7,k). Ainsi, lorsqu'une haute tension de programmation Vpp1 est appliquée à la ligne de bit BL(7,k) pour programmer par exemple la cellule mémoire comprenant le transistor de sélection ST(i,7,k), ce transistor reçoit une tension de grille de forte valeur Vp1 pour laisser passer la haute tension Vpp1 tandis que tous les autres transistors de sélection connectés à cette ligne de bit, notamment le transistor ST(i-2,7,k), reçoivent une tension de grille nulle et sont dans l'état bloqué. Ces transistors ne participant pas au processus de programmation présentent un seuil de claquage plus bas que celui du transistor ST(i,7,k) et limitent ainsi la tension maximale Vpp1 pouvant être appliquée à la ligne de bit.

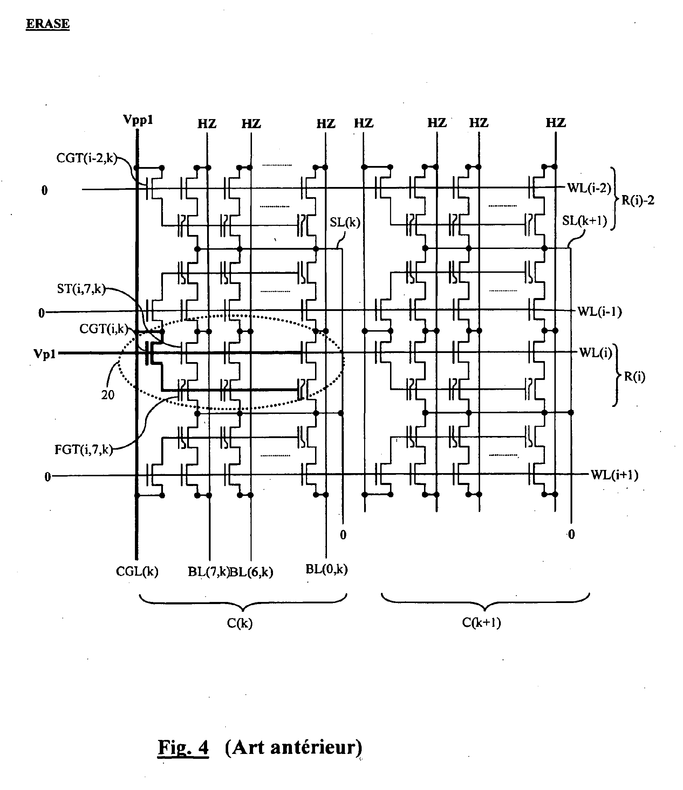

Comme autre exemple, la figure 4 représente une mémoire EEPROM identique à celle de la figure 3 mais ayant des cellules mémoire en cours d'effacement. La mémoire comprend des transistors de contrôle de grille, par exemple des transistors CGT(i-2,k) et CGT(i,k), dont les drains sont connectés à une ligne de contrôle de grille commune, par exemple une ligne CGL(k). Lorsqu'une haute tension d'effacement Vpp1 est appliquée à la ligne de contrôle de grille CGL(k) pour effacer par exemple des cellules mémoire reliées au transistor CGT(i,k), ce transistor reçoit une tension de grille de forte valeur Vp1 pour laisser passer la haute tension tandis que tous les autres transistors reliés à cette ligne de contrôle de grille, notamment le transistor CGT(i-2,k), reçoivent une tension de grille nulle et sont dans l'état bloqué. Ces transistors qui ne participent pas au processus d'effacement présentent un seuil de claquage plus bas que celui du transistor CGT(i,k) et limitent ainsi la tension maximale Vpp1 pouvant être appliquée à la ligne de contrôle de grille.

La présente invention vise ainsi un procédé permettant d'augmenter le seuil de claquage de transistors connectés à une ligne recevant une haute tension de programmation ou d'effacement.

La présente invention vise également une structure de mémoire EEPROM, notamment une mémoire effaçable par mot, permettant d'augmenter le seuil de claquage de transistors connectés à une ligne recevant une haute tension de programmation ou d'effacement.

L'invention est définie par les revendications 1 et 6.

Pour atteindre ces objectifs, la présente invention se fonde sur l'observation que la tension de claquage d'un transistor MOS augmente de façon quasi proportionnelle avec la tension de grille appliquée au transistor. Plus particulièrement, des expérimentations ont montré que lorsque la tension de grille d'un transistor est différente de zéro, il se crée dans le canal du transistor une accumulation de charges électriques qui repousse le seuil de claquage de la diode drain-substrat. On a notamment constaté que l'application d'une tension de compensation de 5 V à la grille d'un transistor recevant une tension de programmation ou d'effacement sur son drain, permettait d'augmenter le seuil de claquage du transistor de 2 V, pour atteindre par exemple 14 V au lieu de 12 V.

Une première idée de l'invention est ainsi d'appliquer une tension de compensation non nulle sur la grille des transistors qui ne participent pas au processus de programmation ou d'effacement mais qui reçoivent une tension de programmation ou d'effacement sur leur drain.

Toutefois, appliquer une tension de grille non nulle à un transistor ne participant pas au processus de programmation ou d'effacement, signifie que ce transistor va devenir passant et va transférer une fraction de la haute tension sur le drain du transistor à grille flottante auquel il est connecté (s'il s'agit d'un transistor de sélection) ou sur les grilles d'un ensemble de transistors à grille flottante (s'il s'agit d'un transistor de contrôle de grille). Dans ces conditions, le ou les transistors à grille flottante concernés sont exposés à un risque de programmation ou d'effacement parasite appelé programmation douce ("soft programming") ou effacement doux ("soft erase").

Pour pallier cet inconvénient, une autre idée de l'invention est d'appliquer une tension d'inhibition sur la source ou sur la grille du ou des transistors à grille flottante concerné(s), pour bloquer le phénomène de programmation douce ou d'effacement doux.

Plus particulièrement, la présente invention se rapporte à un procédé de programmation ou d'effacement de cellules mémoire comprenant chacune un transistor de sélection connecté à un transistor à grille flottante, chaque transistor comprenant une grille, une première borne de conduction et une seconde borne de conduction, le procédé comprenant une étape d'application simultanée d'une haute tension de programmation ou d'effacement à au moins une cellule mémoire devant être programmée ou devant être effacée et à une borne d'au moins un transistor ne participant pas au processus de programmation ou d'effacement. Selon l'invention, le procédé comprend les étapes consistant à appliquer une tension de compensation non nulle à la grille du transistor ne participant pas au processus de programmation ou d'effacement, de manière à augmenter un seuil de claquage du transistor, et appliquer une tension d'inhibition à la grille ou à une borne d'au moins un transistor à grille flottante connecté au transistor ayant son seuil de claquage augmenté, pour inhiber un phénomène de programmation douce ou d'effacement doux du transistor à grille flottante.

Selon un mode de réalisation, une étape de programmation comprend les étapes consistant à appliquer une haute tension de programmation à la première borne d'au moins un premier transistor de sélection appartenant à une cellule mémoire devant être programmée et à la première borne d'au moins un second transistor de sélection appartenant à une cellule mémoire ne devant pas être programmée, appliquer la tension de compensation à la grille du second transistor de sélection, de manière à augmenter le seuil de claquage du transistor, et appliquer une tension d'inhibition de programmation douce à la grille d'un transistor à grille flottante relié au second transistor de sélection.

Selon un mode de réalisation, le procédé est appliqué à une mémoire dans laquelle les cellules mémoire sont agencées en mots mémoire, chaque mot mémoire comprenant un transistor de contrôle de grille connecté aux grilles de contrôle des transistors à grille flottante du mot, et une étape d'effacement comprend les étapes consistant à appliquer une haute tension d'effacement à la première borne d'au moins un premier transistor de contrôle de grille d'un premier mot mémoire devant être effacé et à la première borne d'au moins un second transistor de contrôle de grille d'un second mot mémoire ne devant pas être effacé, appliquer la tension de compensation à la grille du second transistor de contrôle de grille, de manière à augmenter le seuil de claquage du transistor, et appliquer une tension d'inhibition d'effacement doux à des bornes des transistors à grille flottante du second mot mémoire.

Selon un mode de réalisation, le procédé comprend une étape d'agencement des cellules mémoire pour former un plan mémoire présentant les caractéristiques suivantes : les cellules mémoire sont agencées selon des lignes, les grilles des transistors de sélection des cellules mémoire d'une même ligne sont connectées à une ligne de mot commune, les premières bornes des transistors de sélection des cellules mémoire sont reliées à des lignes de bit transversales aux lignes de mot, les lignes de bit sont regroupées en colonnes, les cellules mémoire d'une même colonne et d'une même ligne forment un mot mémoire, chaque mot mémoire comprend un transistor de contrôle de grille ayant sa première borne connectée aux grilles de contrôle des transistors à grille flottante du mot, les grilles des transistors de contrôle de grille des mots mémoire appartenant à une même colonne sont connectées à une ligne de sélection de colonne commune, et les premières bornes des transistors de contrôle de grille des mots mémoire appartenant à une même ligne sont reliées à une ligne de contrôle de grille commune qui est parallèle à la ligne de mot de la ligne.

Selon un mode de réalisation, le procédé comprend une étape de connexion des secondes bornes des transistors à grille flottante de chaque colonne à une ligne de contrôle commune à tous les transistors à grille flottante de la colonne.

L'invention concerne également une mémoire effaçable et programmable électriquement comprenant des cellules mémoire comprenant chacune un transistor de sélection connecté à un transistor à grille flottante, chaque transistor comprenant une grille, une première borne de conduction et une seconde borne de conduction, et des moyens pour appliquer simultanément une haute tension de programmation ou d'effacement à au moins une cellule mémoire devant être programmée ou devant être effacée et à une borne d'au moins un transistor ne participant pas au processus de programmation ou d'effacement. Selon l'invention, la mémoire comprend des moyens pour appliquer une tension de compensation non nulle à la grille du transistor ne participant pas au processus de programmation ou d'effacement, de manière à augmenter un seuil de claquage du transistor, et appliquer une tension d'inhibition à la grille ou à une borne d'au moins un transistor à grille flottante connecté au transistor ayant son seuil de claquage augmenté, pour inhiber un phénomène de programmation douce ou d'effacement doux du transistor à grille flottante.

Selon un mode de réalisation, la mémoire comprend des moyens de programmation agencés pour appliquer une haute tension de programmation à la première borne d'au moins un premier transistor de sélection appartenant à une cellule mémoire devant être programmée et à la première borne d'au moins un second transistor de sélection appartenant à une cellule mémoire ne devant pas être programmée, appliquer la tension de compensation à la grille du second transistor de sélection, de manière à augmenter le seuil de claquage du transistor, et appliquer une tension d'inhibition de programmation douce à la grille d'un transistor à grille flottante relié au second transistor de sélection.

Selon un mode de réalisation, les grilles des transistors de sélection des cellules mémoire sont connectées à des lignes de mot, les cellules mémoire sont agencées en mots mémoire, chaque mot mémoire comprenant un transistor de contrôle de grille connecté aux grilles de contrôle des transistors à grille flottante du mot, et la mémoire comprend des moyens d'effacement de cellules mémoire agencés pour appliquer une haute tension d'effacement à la première borne d'au moins un premier transistor de contrôle de grille d'un premier mot mémoire devant être effacé et à la première borne d'au moins un second transistor de contrôle de grille d'un second mot mémoire ne devant pas être effacé, appliquer la tension de compensation à la grille du second transistor de contrôle de grille, de manière à augmenter le seuil de claquage du transistor, et appliquer une tension d'inhibition d'effacement doux à des bornes des transistors à grille flottante du second mot mémoire.

Selon un mode de réalisation, les cellules mémoire sont agencées dans un plan mémoire présentant les caractéristiques structurelles suivantes : les cellules mémoire sont agencées selon des lignes, les grilles des transistors de sélection des cellules mémoire d'une même ligne sont connectées à une ligne de mot commune, les premières bornes des transistors de sélection des cellules mémoire sont reliées à des lignes de bit transversales aux lignes de mot, les lignes de bit sont regroupées en colonnes, les cellules mémoire d'une même colonne et d'une même ligne forment un mot mémoire, chaque mot mémoire comprend un transistor de contrôle de grille ayant sa première borne connectée aux grilles de contrôle des transistors à grille flottante du mot, les grilles des transistors de contrôle de grille des mots mémoire appartenant à une même colonne sont connectées à une ligne de sélection de colonne commune, et les premières bornes des transistors de contrôle de grille des mots mémoire appartenant à une même ligne sont reliées à une ligne de contrôle de grille commune qui est parallèle à la ligne de mot de la ligne.

Selon un mode de réalisation, les secondes bornes des transistors à grille flottante de chaque colonne sont connectées à une ligne de contrôle commune à tous les transistors à grille flottante de la colonne.

Ces objets, caractéristiques et avantages ainsi que d'autres de la présente invention seront exposés plus en détail dans la description suivante du procédé de programmation et d'effacement de cellules mémoire selon l'invention, et d'une architecture de mémoire EEPROM permettant la mise en oeuvre de ce procédé, faite à titre non limitatif en relation avec les figures jointes parmi lesquelles :
- les figures 1A, 1B, 1C précédemment décrites représentent respectivement le schéma électrique d'une cellule mémoire EEPROM et un exemple de réalisation de la cellule mémoire sur substrat de silicium, vu en coupe et vu de dessus,
- la figure 2 représente une architecture classique de mémoire EEPROM effaçable par mot,
- les figures 3 et 4 représentent des combinaisons de tensions classiques appliquées à la mémoire EEPROM de la figure 2, respectivement pendant une phase de programmation et une phase d'effacement de cellules mémoire,
- les figures 5 et 6 représentent des combinaisons de tensions appliquées à la mémoire EEPROM de la figure 2, respectivement pendant une phase de programmation et une phase d'effacement de cellules mémoire, et illustrent un premier aspect du procédé selon l'invention,
- la figure 7 représente une structure de mémoire EEPROM effaçable par mot selon l'invention permettant la mise en oeuvre de deux aspects du procédé selon l'invention, et
- les figures 8 et 9 représentent des combinaisons de tensions selon l'invention appliquées à la mémoire EEPROM de la figure 7, respectivement pendant une phase de programmation et une phase d'effacement de cellules mémoire.

On décrira dans ce qui suit un exemple de mise en oeuvre du procédé de l'invention dans une mémoire effaçable par mot, après avoir analysé de façon plus détaillée, dans le contexte d'une structure de mémoire effaçable par mot, le problème technique que l'invention vise à résoudre.

### Architecture d'une mémoire effaçable par mot classique et analyse détaillée du problème technique

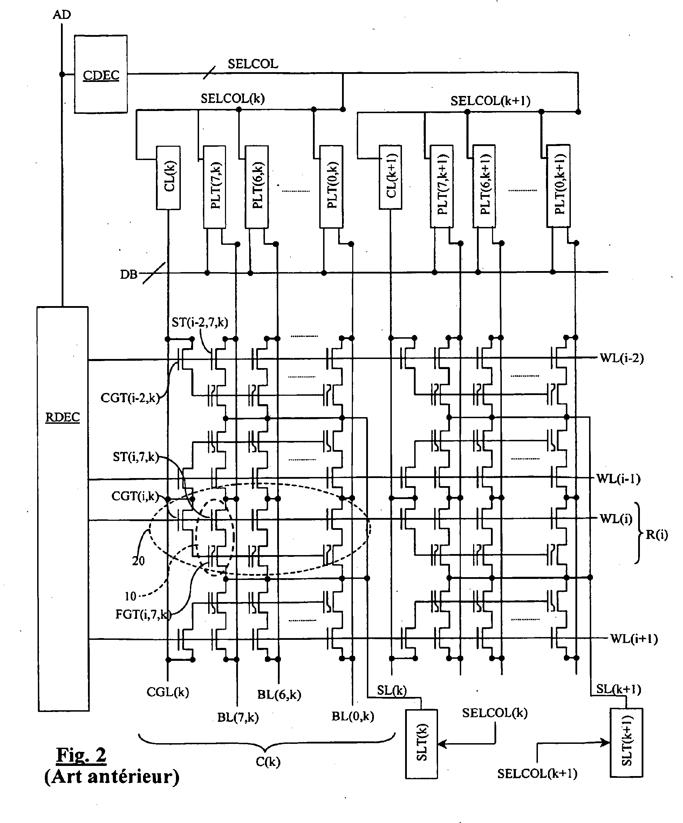

La figure 2 représente l'architecture classique d'une mémoire EEPROM effaçable par mot. La mémoire comporte un plan mémoire composé de cellules mémoire agencées suivant des lignes ("rows") référencées R(i), "i" étant le rang d'une ligne. Comme décrit plus haut, chaque cellule mémoire 10 comporte un transistor de sélection ST et un transistor à grille flottante FGT. Les drains des transistors de sélection ST des cellules mémoire sont connectés à des lignes de bit BL(j,k), "j,k" étant le rang des lignes de bit avec j allant ici de 0 à 7. Les grilles des transistors de sélection ST sont connectées à des lignes de mot WL(i), les cellules mémoire d'une même ligne R(i) ayant la grille de leur transistor de sélection ST connectée à la même ligne de mot WL (i).

Les lignes de bit sont regroupées en colonnes C(k), une colonne de rang k comprenant ici huit lignes de bit BL(0,k) à BL(7,k). Les cellules mémoire d'une même ligne R(i) et d'une même colonne C(k), ici huit cellules mémoire, sont reliées à une ligne de contrôle de grille CGL(k) par l'intermédiaire d'un transistor de contrôle de grille CGT(i,k). Chaque ligne de contrôle de grille CGL(k) est commune à toutes les cellules mémoire de la colonne C(k) de rang correspondant. Ainsi, un mot mémoire 20 appartenant à une ligne R(i) et à une colonne C(k) comprend huit cellules mémoire et un transistor de contrôle de grille CGT(i,k). Ce transistor de contrôle de grille a sa source reliée à la ligne de contrôle de grille CGL(k), sa grille connectée à la ligne de mot correspondante WL(i), et sont drain est connecté aux grilles de contrôle des transistors à grille flottante FGT du mot. Enfin, les sources des transistors à grille flottante FGT des mots appartenant à une même colonne C(k) sont connectées à une ligne de source commune SL(k).

Les phases de programmation ou d'effacement de cellules mémoire sont contrôlées au moyen des éléments suivants:
- des verrous de programmation PLT(j,k) à raison de huit verrous PLT(O,k) à PLT(7,k) par colonne, chaque verrou étant connecté à une ligne de bit de rang correspondant,
- des verrous de colonne CL(k) à raison d'un verrou par colonne, chaque verrou de colonne étant connecté à la ligne de contrôle de grille CGL (k) de la colonne de rang correspondant,
- des verrous de source SLT(k) à raison d'un verrou par colonne, chaque verrou de source étant connecté à la ligne de source SL(k) de la colonne de rang correspondant,
- un décodeur de colonne CDEC recevant une adresse de mot AD et fournissant, en fonction de cette adresse, des signaux de sélection de colonne SELCOL(k) aux verrous de programmation, aux verrous de colonne et aux verrous de source, et
- un décodeur de ligne RDC1 pour polariser les lignes de - mot WL(i) et sélectionner une ligne de mot en programmation ou en effacement en fonction de l'adresse de mot AD.

Chaque verrou de programmation PLT(j,k) a une entrée reliée à un bus de données DB et applique à la ligne de bit concernée une tension pouvant présenter trois valeurs : HZ (potentiel flottant), 0 V (masse) et Vpp1 (haute tension de programmation). Chaque verrou de colonne CLT(k) applique à la ligne de contrôle de grille concernée CGL(k) une tension de contrôle de grille pouvant présenter trois valeurs : HZ (potentiel flottant), 0 V (masse) et Vpp1 (haute tension d'effacement, généralement égale à la haute tension de programmation). Chaque verrou de source SLT(k) applique à la ligne de source concernée une tension de source égale à HZ ou à 0 V.

Le décodeur de ligne RDEC applique à chaque ligne de mot WL(i) une tension de ligne de mot pouvant présenter trois valeurs : 0 V ou Vp1, Vp1 étant une tension de grille permettant de laisser passer la tension Vpp1 à travers un transistor de contrôle de grille (effacement) ou à travers un transistor de sélection (programmation). La tension Vp1 est par exemple égale à 15 V si la tension Vpp1 est égale à 12V.

Des tensions de lecture appliquées au plan mémoire ne seront pas décrites ici dans un souci de simplicité, l'invention ne concernant pas la lecture des cellules mémoire.

### a - Programmation de cellules mémoire

La figure 3 décrite partiellement plus haut représente une combinaison de tensions appliquée au plan mémoire de la figure 2 pour la programmation de cellules mémoire. Les cellules mémoire à programmer choisies à titre d'exemple sont ici deux cellules mémoire de rangs respectifs i,7,k et i,6,k du mot mémoire 20.

On distingue les tensions suivantes:
- tension appliquée à la ligne de mot concernée WL(i) : Vp1
- tension appliquée aux autres lignes de mot : 0 V
- tension appliquée aux lignes de bit concernées BL(7,k), BL(6,k) : Vpp1
- tension appliquée aux autres lignes de bit : HZ (appartenant à la même colonne et aux autres colonnes)
- tension appliquée à la ligne de contrôle de grille concernée CGL(k) : 0 V
- tension appliquée aux autres lignes de contrôle de grille du plan mémoire : HZ
- tension appliquée à la ligne de source SL(k) concernée: HZ
- tension appliquée aux autres lignes de source SL(k) du plan mémoire : HZ.

Ainsi, les transistors de sélection ST(i,7,k), ST(i,6,k) des deux cellules mémoire concernées sont dans l'état passant et appliquent la tension Vpp1 aux drains des transistors à grille flottante FGT(i,7,k), FGT(i,6,k), dont la grille reçoit la tension 0 V, les sources étant à haute impédance.

Simultanément, tous les autres transistors d'accès reliés aux lignes de bit concernées BL(7,k), BL(6,k) reçoivent la tension Vpp1 sur leur drain et la tension 0 V sur leur grille, par exemple le transistor ST(i-2,7,k) de la ligne WL(i-2). Ces transistors sont bloqués mais imposent leur seuil de claquage à la ligne de bit, de sorte que la tension de programmation Vpp1 ne peut être portée au-delà de cette valeur.

### b - effacement de cellules mémoire

La figure 4 décrite partiellement plus haut représente une combinaison de tensions appliquées au plan mémoire de la figure 2 pour l'effacement de cellules mémoire. Les cellules mémoire à effacer choisies à titre d'exemple sont ici les cellules mémoire du mot mémoire 20.

On distingue les tensions suivantes:
- tension appliquée à la ligne de mot concernée WL(i) : Vp1
- tension appliquée aux autres lignes de mot : 0 V
- tension appliquée aux lignes de bit de la colonne concernée : HZ
- tension appliquée aux autres lignes de bit du plan mémoire: HZ
- tension appliquée à la ligne de contrôle de grille concernée CGL(k) : Vpp1
- tension appliquée aux autres lignes de contrôle de grille du plan mémoire : HZ
- tension appliquée à la ligne de source SL(k) concernée : 0 V
- tension appliquée aux autres lignes de source SL(k) du plan mémoire : HZ.

Ainsi, le transistor de contrôle de grille CGT(i,k) du mot mémoire 20 est passant et applique la tension Vpp1 aux grilles des transistors à grille flottante du mot mémoire, dont le drain est mis à haute impédance et dont les sources sont à 0 V.

Simultanément, tous les autres transistors de contrôle de grille reliés à la ligne de contrôle de grille CGL(k) reçoivent la tension Vpp1 sur leur drain et la tension 0 V sur leur grille, par exemple le transistor CGT(i-2,7,k) de la ligne WL(i-2). Ces transistors sont bloqués mais imposent leur seuil de claquage à la ligne de contrôle de grille CGT(k), de sorte que la tension d'effacement Vpp1 ne peut être portée au-delà de cette valeur.

### Premier aspect du procédé selon l'invention

Selon un premier aspect de l'invention, une tension de compensation est appliquée sur les grilles des transistors ne participant pas au processus de programmation ou d'effacement mais recevant la haute tension sur leur drain. Comme cela vient d'être vu, il s'agit des transistors de sélection, pendant les phases de programmation, et des transistors de contrôle de grille, pendant les phases d'effacement. Cet aspect de l'invention permet d'accroître le seuil de claquage de ces transistors, de sorte qu'une tension de programmation ou d'effacement de plus forte valeur peut être utilisée.

Plus particulièrement, les tensions prévues par le procédé de l'invention sont les suivantes :
- Vc : tension de compensation, par exemple 5 V pour rehausser de 2 V le seuil de claquage des transistors,
- Vpp2 : haute tension de programmation ou d'effacement supérieure à la tension Vpp1, par exemple 14 V au lieu de 12 V si la tension Vc est égale à 5V,
- Vp2 : tension de grille de forte valeur supérieure à Vp1 permettant de laisser passer la haute tension Vpp2, par exemple 17 V au lieu de 15 V,
- HZ (potentiel flottant) et 0 V (masse).

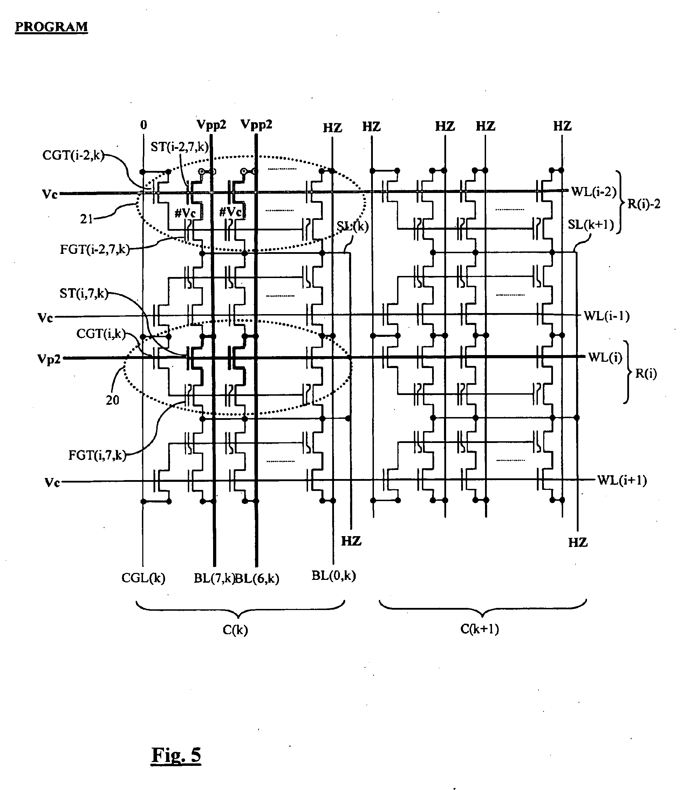

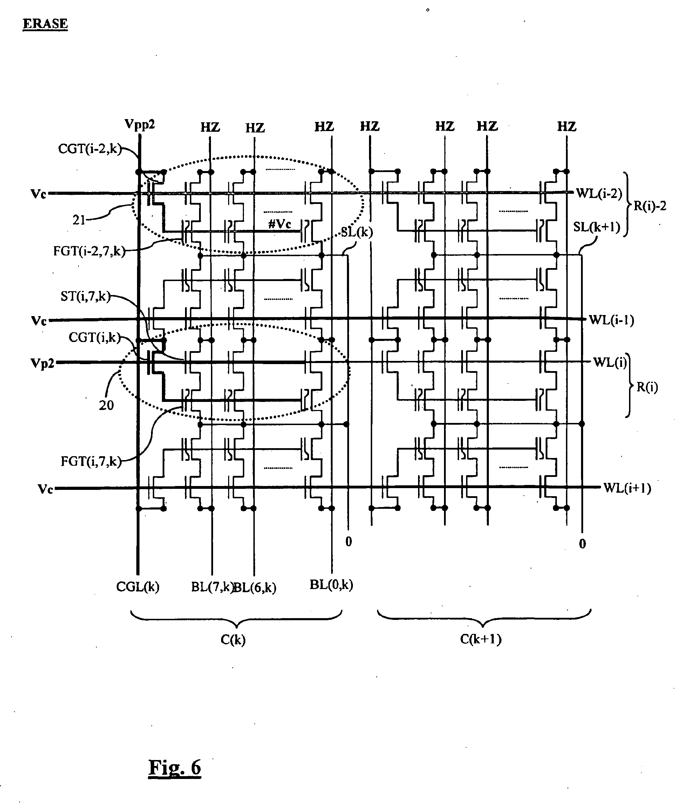

Ce premier aspect de l'invention est illustré sur les figures 5 et 6.

### a - Programmation de cellules mémoire

La figure 5 représente une combinaison de tensions appliquée au plan mémoire de la figure 2 pour la programmation de cellules mémoire. Les cellules mémoire à programmer choisies à titre d'exemple sont de nouveau les cellules mémoire de rangs i,7,k et i,6,k du mot mémoire 20.

On distingue les tensions suivantes:
- tension appliquée à la ligne de mot concernée WL (i): Vp2
- tension appliquée aux autres lignes de mot du plan mémoire : Vc
- tension appliquée aux lignes de bit concernées BL(7,k), BL(6,k) : Vpp2
- tension appliquée aux autres lignes de bit du plan mémoire: HZ
- tension appliquée à la ligne de contrôle de grille concernée CGL (K) : 0 V
- tension appliquée aux autres lignes de contrôle de grille du plan mémoire : HZ
- tension appliquée à la ligne de source SL(k) concernée : HZ
- tension appliquée aux autres lignes de source du plan mémoire : HZ.

Comme précédemment les transistors de sélection ST(i,7,k), ST(i,6,k) des deux cellules mémoire concernées sont dans l'état passant et appliquent la tension Vpp2 aux drains des transistors à grille flottante FGT(i,7,k), FGT(i,6,k) dont la grille reçoit la tension 0 V, leurs sources étant à haute impédance.

Simultanément, tous les autres transistors d'accès reliés aux lignes de bit BL(7,k), BL(6,k) reçoivent la tension Vpp2 sur leur drain et la tension de compensation Vc sur leur grille, par exemple le transistor de sélection ST(i-2,7,k) relié à la ligne de mot WL(i-2). Ces transistors imposent toujours leur seuil de claquage à la ligne de bit, mais ce seuil est maintenant augmenté de 2 V (Vpp2-Vpp1) .

### b - effacement de cellules mémoire

La figure 6 représente une combinaison de tensions appliquées au plan mémoire de la figure 2 pour l'effacement de cellules mémoire. Les cellules mémoire à effacer choisies à titre d'exemple sont de nouveau les cellules mémoire appartenant au mot mémoire 20.

On distingue les tensions suivantes :
- tension appliquée à la ligne de mot concernée WL(i) : Vp2
- tension appliquée aux autres lignes de mot du plan mémoire: Vc,
- tension appliquée aux lignes de bit du plan mémoire : HZ,
- tension appliquée à la ligne de contrôle de grille concernée CGL(k) : Vpp2,
- tension appliquée aux autres lignes de contrôle de grille du plan mémoire : HZ,
- tension appliquée à la ligne de source SL(k) concernée : 0 V,
- tension appliquée aux autres lignes de source SL(k) du plan mémoire: HZ.

Comme précédemment le transistor de contrôle de grille CGT(i,k) du mot mémoire 20 est passant et applique la tension Vpp2 aux grilles des transistors à grille flottante du mot mémoire, dont le drain est mis à haute impédance et dont les sources sont à 0 V.

Simultanément, tous les autres transistors de contrôle de grille reliés à la ligne de contrôle de grille CGL(k) reçoivent la tension Vpp2 sur leur drain et la tension de compensation Vc sur leur grille, par exemple le transistor CGT(i-2,7,k) de la ligne WL(i-2). Ces transistors imposent toujours leur seuil de claquage à la ligne de contrôle de grille CGT(k), mais celui-ci est maintenant augmenté de 2 V (Vpp2-Vpp1) .

### c - Second aspect de l'invention - Contraintes imposées par la structure de mémoire classique

Dans les configurations représentées sur les figures 5 et 6, les transistors recevant la tension de compensation Vc sur leur grille et recevant simultanément la tension Vpp2 sur leur drain sont dans l'état passant et appliquent sur les drains des transistors à grille flottante correspondants (programmation, figure 5) ou sur les sources des transistors à grille flottante correspondants (effacement, figure 6) une tension #Vc sensiblement égale à Vc-Vt, Vt étant la tension de seuil de ces transistors, soit une tension #Vc sensiblement égale à 4 V si la tension Vc est égale à 5 V.

Par exemple, en figure 5, le transistor de sélection ST(i-2,7,k) appartenant à un mot mémoire 21 applique la tension #Vc à la grille du transistor FGT(i-2,7,k). Les autres transistors de sélection appartenant au même mot mémoire 21 appliquent cette même tension aux autres transistors à grille flottante du mot. En figure 6, le transistor de contrôle de grille CGT(i-2,7,k) du mot mémoire 21 applique la tension #Vc à la grille du transistor FGT(i-2,7,k) et aux grilles des autres transistors du mot mémoire 21.

Il s'ensuit que ces transistors à grille flottante subissent un phénomène de programmation douce ou d'effacement doux, en d'autres termes un phénomène de programmation ou d'effacement provoqué par une tension nettement inférieure à la tension Vpp2, ici la tension #Vc. Ce phénomène est à même, à long terme, de provoquer une injection de charges électriques dans les grilles flottantes ou une extraction de charges électriques, entraînant alors une corruption de données.

Selon un second aspect de l'invention, il est prévu d'appliquer une tension d'inhibition égale à #Vc sur les grilles de contrôle des transistors à grille flottante recevant la tension #Vc sur leur drain (phase de programmation) ou d'appliquer une tension d'inhibition égale à #Vc sur les sources des transistors à grille flottante recevant la tension #Vc sur leur grille (phase d'effacement). Ces tensions d'inhibition neutralisent le champ électrique causé par la tension #Vc et inhibent le processus de programmation douce ou d'effacement doux.

Il apparaît toutefois que la structure de la mémoire de la figure 2 ne permet pas d'appliquer une telle tension de compensation. En phase de programmation (figure 5), la grille de contrôle des transistors à grille flottante reçoit en effet la tension 0 V présente sur la ligne de contrôle de grille CGL(k) et l'application de la tension #Vc par tout moyen interrupteur prévu à cet effet provoquerait un court-circuit entre la tension #Vc et la masse. En phase d'effacement (figure 6), il faudrait tout d'abord individualiser les lignes de contrôle de source pour chaque mot mémoire, afin de permettre l'application de la tension #Vc sur les bornes de source des mots mémoire de la colonne concernée C(k) tout en appliquant la tension 0 V sur les bornes de source du mot à effacer, ce qui compliquerait considérablement la structure de la mémoire. En admettant que cela soit réalisé, il se produirait néanmoins un court-circuit entre la tension #Vc et la masse par l'intermédiaire des lignes de bit concernées. En effet, les transistors à grille flottante et les transistors de sélection du mot mémoire 20 à effacer sont dans l'état passant et les sources des transistors à grille flottante du mot 20 sont donc reliées aux lignes de bit. De même, les transistors à grille flottante et les transistors de sélection des mots mémoire à ne pas effacer, par exemple le mot mémoire 21, sont également dans l'état passant, et les sources des transistors à grille flottante de ces mots mémoire sont donc reliées aux mêmes lignes de bit. En conséquence, la tension #Vc ne peut être appliquée aux sources des transistors des mots mémoires à ne pas effacer pendant que les sources du mot mémoire à effacer sont reliées à la masse, car toutes les sources sont interconnectées.

Ainsi, un objectif secondaire de l'invention est de prévoir une architecture de mémoire EEPROM effaçable par mot dans laquelle la tension d'inhibition #Vc peut être appliquée aux transistors à grille flottante sans provoquer de court-circuit.

### Exemple d'architecture de mémoire effaçable par mot selon l'invention

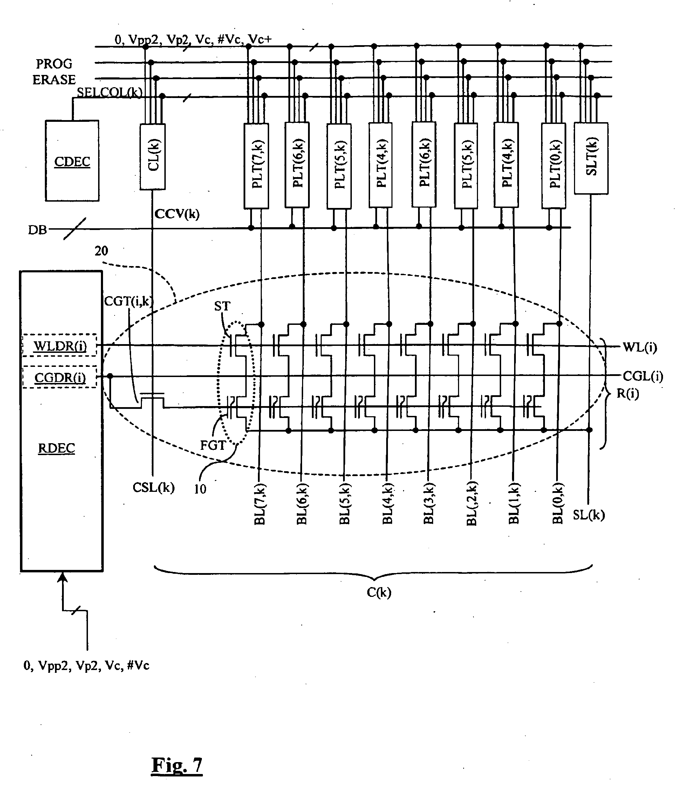

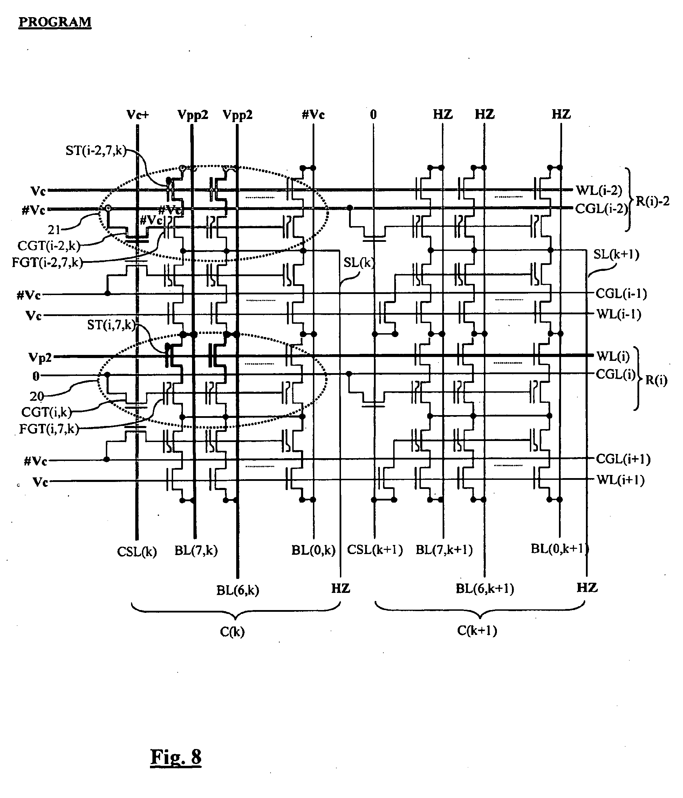

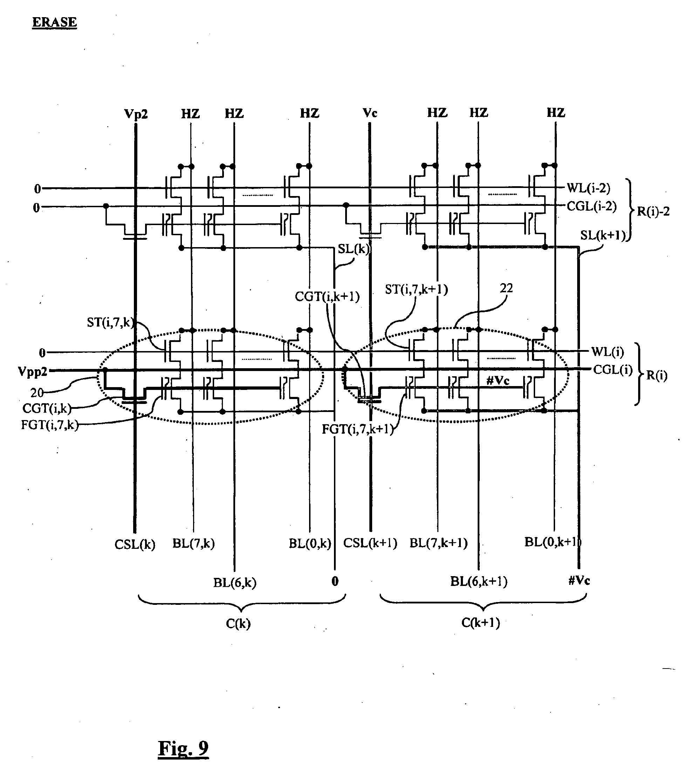

La figure 7 représente une mémoire EEPROM ayant un plan mémoire permettant de mettre pleinement en oeuvre le procédé selon l'invention. L'architecture générale du plan mémoire classique est conservée en ce que chaque cellule mémoire 10 comprend un transistor à grille flottante FGT et un transistor de sélection ST, les cellules mémoire étant regroupées en mots mémoire comprenant chacun huit cellules mémoire et un transistor de contrôle de grille. Dans un souci de simplicité de la figure, un seul mot mémoire comprenant huit cellules mémoire et un transistor de contrôle de grille est représenté, ici le mot mémoire 20 de rang i,k appartenant à la ligne R(i) et à la colonne C(k). Sont également conservés les éléments périphériques au plan mémoire permettant d'appliquer au plan mémoire les tensions nécessaires à la programmation et à l'effacement des cellules mémoire. On retrouve ainsi des verrous de programmation PLT(j,k), les verrous de colonne CL(k), des verrous de ligne de source SLT(k), un décodeur de colonne CDEC et un décodeur de ligne RDEC. Ces éléments sont désignés par les mêmes références que précédemment mais sont sensiblement modifiés de façon à permettre l'application au plan mémoire des tensions 0 V, HZ, Vpp2, Vp2, Vc, #Vc, ainsi qu'une tension Vc+. Ces éléments reçoivent également des signaux PROG et ERASE qui leur permettent de savoir si le processus en cours est une programmation ou un effacement, de manière à fournir ces tensions d'une manière appropriée qui sera décrite plus loin en relation avec les figures 8 et 9.

Le plan mémoire selon l'invention se distingue de celui de la figure 2 en ce que le drain du transistor de contrôle de grille de chaque mot mémoire, par exemple le drain du transistor CGT(i,k) du mot mémoire 20, n'est plus connecté aux drains des transistors de contrôle de grille des mots appartenant à la même colonne C(k) mais est au contraire connecté aux drains des transistors de contrôle de grille des mots appartenant à la même ligne R(i) et appartenant donc à des colonnes différentes. Ainsi, chaque ligne de contrôle de grille CGL(i) du plan mémoire est parallèle à la ligne de mot WL (i) de rang correspondant et présente un rang d'indice "i" au lieu d'un rang d'indice "k". Comme autre modification du plan mémoire, les lignes de contrôle de grille ne sont plus pilotées par des verrous de colonne mais par le décodeur de ligne RDEC. Celui-ci comprend ainsi, pour chaque ligne R(i) à contrôler, un pilote de ligne de mot WLDR(i) qui fournit la tension à appliquer à la ligne de mot WL(i), et un pilote de contrôle de grille CGDR(i) qui fournit la tension à appliquer à la ligne de contrôle de grille CGL(i). Enfin, une dernière modification apportée au plan mémoire est que les grilles des transistors de contrôle de grille d'une même colonne C(k) sont reliées à une ligne de sélection de colonne CSL(k) commune qui remplace ainsi la ligne de contrôle de grille CGL(k) classique (Cf. figure 2). La ligne CSL(k) est pilotée par le verrou de colonne CL(k), qui lui applique une tension égale à 0, Vc+ ou Vp2 selon les cas de figure, ainsi que cela va maintenant être décrit. La tension Vc+ est une tension de grille qui permet de laisser passer la tension #Vc à travers un transistor et est par exemple égale à 7 V si #Vc est égale à 4 V.

### a - Programmation de cellules mémoire

La figure 8 représente une combinaison de tensions selon l'invention appliquée au plan mémoire de la figure 7 pour la programmation de cellules mémoire. Les cellules mémoire à programmer choisies à titre d'exemple sont les cellules mémoire de rangs respectifs i,7,k et i,6,k appartenant au mot mémoire 20.

On distingue les tensions suivantes :
- tension appliquée à la ligne de mot concernée WL(i) : Vp2
- tension appliquée aux autres lignes de mot du plan mémoire, par exemple la ligne de mot WL(i-2) : Vc
- tension appliquée aux lignes de bit concernées BL(7,k), BL(6,k) : Vpp2
- tension appliquée aux autres lignes de bit de la colonne concernée C(k), par exemple la ligne de bit BL (0,k) : #Vc
- tension appliquée aux autres lignes de bit du plan mémoire : HZ
- tension appliquée à la ligne de contrôle de grille concernée CGL(i) : 0 V
- tension appliquée aux autres lignes de contrôle de grille du plan mémoire, par exemple la ligne de contrôle de grille CGL(i-2) : #Vc
- tension appliquée à la ligne de sélection CSL(k) de la colonne concernée C(k) : Vc+,
- tension appliquée aux autres lignes de sélection CSL(k) du plan mémoire : 0 V
- tension appliquée à la ligne de source SL(k) concernée: HZ
- tension appliquée aux autres lignes de source SL(k) du plan mémoire : HZ.

Les transistors de sélection ST(i,7,k), ST(i,6,k) des deux cellules mémoire concernées sont dans l'état passant et appliquent la tension Vpp2 aux drains des transistors à grille flottante FGT(i,7,k), FGT(i,6,k), dont la grille reçoit la tension 0 V, les sources étant à haute impédance.

Simultanément, dans les autres cellules mémoire reliées aux lignes de bit concernées BL(7,k), BL(6,k) :
1) les transistors de sélection ST reçoivent la tension Vpp2 sur leur drain et la tension de compensation Vc sur leur grille, par exemple le transistor ST(i-2,7,k) de la ligne WL(i-2). Ces transistors présentent un seuil de claquage augmenté de 2 V (Vpp2-Vppl).
2) les transistors à grille flottante FGT reçoivent la tension #Vc sur leur drain et la tension #Vc sur leur grille et le risque d'une programmation douce de ces transistors est donc écarté.

### b - effacement de cellules mémoire

La figure 9 représente une combinaison de tensions selon l'invention appliquée au plan mémoire de la figure 7 pour l'effacement de cellules mémoire. Les cellules mémoire à effacer choisies à titre d'exemple sont les cellules mémoire du mot mémoire 20. Les lignes R(i-1) et R(i+1) ne sont pas représentées pour préserver la lisibilité du dessin.

On distingue les tensions suivantes :
- tension appliquée à toutes les lignes de mot du plan mémoire, par exemple WL(i) et WL(i-2) : 0 V
- tension appliquée à toutes les lignes de bit du plan mémoire, toutes colonnes confondues : HZ
- tension appliquée à la ligne de contrôle de grille concernée CGL(i) : Vpp2
- tension appliquée aux autres lignes de contrôle de grille du plan mémoire, par exemple la ligne de contrôle de grille CGL(i-2) : 0 V
- tension appliquée à la ligne de sélection CSL(k) de la colonne concernée C(k) : Vp2,
- tension appliquée aux autres lignes de sélection CSL(k) du plan mémoire : 0 V
- tension appliquée à la ligne de source SL(k) de la colonne concernée: 0 V
- tension appliquée aux autres lignes de source du plan mémoire : #Vc.

Comme précédemment le transistor de contrôle de grille CGT(i,k) du mot mémoire 20 est passant et applique la tension Vpp2 aux grilles des transistors à grille flottante du mot mémoire, dont le drain est mis à haute impédance et dont les sources sont à 0 V.

Simultanément, dans les autres cellules mémoire appartenant à la même ligne R(i), par exemple les cellules mémoire d'un mot mémoire 22 appartenant à la colonne C(k+1) :
1) les transistors de sélection ST reçoivent la tension 0 V sur leur grille et leur drain est à haute impédance, ces transistors sont donc bloqués,
2) le transistor de contrôle de grille CGT(i,k+1) reçoit la tension Vpp2 mais reçoit la tension de compensation Vc sur sa grille via la ligne de sélection CLS(k+1), de sorte que le seuil de claquage de ce transistor est augmenté de 2 V,
3) les transistors à grille flottante FGT du mot mémoire 22 reçoivent la tension #Vc sur leur grille et la tension #Vc sur leur source (via la ligne de source SL(k+1) et le risque d'un effacement doux de ces transistors est donc écarté.

### Autres applications du procédé selon l'invention

Il apparaît dans ce qui précède que le procédé selon l'invention a été initialement conçu pour s'appliquer aux mémoires effaçables par mot. De même, le plan mémoire qui vient d'être décrit a été conçu pour permettre une implémentation simple du procédé sans nécessiter l'ajout d'un nombre excessif de transistors supplémentaires pour la commutation des tensions de compensation et d'inhibition. Il apparaîtra toutefois clairement à l'homme de l'art que l'invention est également applicable à divers autres types de mémoire et architectures de plan mémoire. Notamment, l'invention est applicable à un plan mémoire dépourvu de transistor de contrôle de grille, dans lequel toutes les cellules mémoire d'une ligne R(i), R(i-1), R(i-2), etc.. sont effacées simultanément (effacement dit par page). Dans ce cas, les grilles de contrôle des transistors à grille flottante de chaque ligne sont directement connectées à la ligne de contrôle de grille de la ligne considérée, par exemple CGL(i) pour les cellules mémoire de la ligne R(i), et le décodeur de ligne RDEC applique directement la tension Vpp2 à ces transistors pendant une phase d'effacement de la page. Le problème lié au seuil de claquage des transistors de contrôle de grille est de ce fait résolu de lui-même en raison de la suppression de ces transistors, mais le procédé selon l'invention reste applicable à la phase de programmation, dans la configuration représentée en figure 8 dans laquelle on aurait supprimé les transistors de contrôle de grille. Dans ce cas, la tension #Vc est directement appliquée aux grilles de contrôle des transistors à grille flottante par le décodeur RDEC, par l'intermédiaire des lignes de contrôle de grille CGL.

## Revendications

1. Procédé de programmation ou d'effacement de cellules mémoire (10) comprenant chacune un transistor de sélection (ST) connecté à un transistor à grille flottante (FGT), chaque transistor comprenant une grille, une première borne de conduction et une seconde borne de conduction,
procédé comprenant une étape d'application simultanée d'une haute tension de programmation ou d'effacement à au moins une cellule mémoire devant être programmée ou devant être effacée et à une borne d'au moins un transistor ne participant pas au processus de programmation ou d'effacement,
**caractérisé en ce qu'**il comprend les étapes consistant à :
- appliquer une tension de compensation (Vc) non nulle à la grille du transistor de selection ne participant pas au processus de programmation ou d'effacement, de manière à augmenter un seuil de claquage du transistor, et
- appliquer une tension d'inhibition (#Vc) à la grille ou à une borne d'au moins un transistor à grille flottante (FGT) connecté au transistor ayant son seuil de claquage augmenté, pour inhiber un phénomène de programmation douce ou d'effacement doux du transistor à grille flottante.

2. Procédé selon la revendication 1, dans lequel une étape de programmation comprend les étapes consistant à :
- appliquer une haute tension de programmation (Vpp2) à la première borne d'au moins un premier transistor de sélection (ST(i,7,k)) appartenant à une cellule mémoire devant être programmée et à la première borne d'au moins un second transistor de sélection (ST(i-2,7,k)) appartenant à une cellule mémoire ne devant pas être programmée,
- appliquer la tension de compensation (Vc) à la grille du second transistor de sélection (ST(i-2,7,k)), de manière à augmenter le seuil de claquage du transistor, et
- appliquer une tension d'inhibition de programmation douce (#Vc) à la grille d'un transistor à grille flottante (FGT(i-2,7,k)) relié au second transistor de sélection.

3. Procédé selon l'une des revendications 1 et 2, appliqué à une mémoire dans laquelle les cellules mémoire sont agencées en mots mémoire (20), chaque mot mémoire comprenant un transistor de contrôle de grille (CGT(i,k)) connecté aux grilles de contrôle des transistors à grille flottante du mot, et dans lequel une étape d'effacement comprend les étapes consistant à :
- appliquer une haute tension d'effacement (Vpp2) à la premières borne d'au moins un premier transistor de contrôle de grille (CGT(i,k)) d'un premier mot mémoire (20) devant être effacé et à la première borne d'au moins un second transistor de contrôle de grille (CGT(i,k+1)) d'un second mot mémoire (22) ne devant pas être effacé,
- appliquer la tension de compensation (Vc) à la grille du second transistor de contrôle de grille (CGT(i,k+1)), de manière à augmenter le seuil de claquage du transistor, et
- appliquer une tension d'inhibition d'effacement doux (#Vc) à des bornes des transistors à grille flottante (FGT) du second mot mémoire.

4. Procédé selon l'une des revendications 1 à 3, comprenant une étape d'agencement des cellules mémoire pour former un plan mémoire présentant les caractéristiques suivantes :
- les cellules mémoire sont agencées selon des lignes (R(i)),
- les grilles des transistors de sélection (ST) des cellules mémoire d'une même ligne (R(i)) sont connectées à une ligne de mot (wL(i)) commune,
- les premières bornes des transistors de sélection (ST) des cellules mémoire sont reliées à des lignes de bit (BL(j,k)) transversales aux lignes de mot (WL(i)),
- les lignes de bit sont regroupées en colonnes (C(k)),
- les cellules mémoire d'une même colonne (C(k)) et d'une même ligne (R(i)) forment un mot mémoire (20),
- chaque mot mémoire comprend un transistor de contrôle de grille (CGT(i,k)) ayant sa première borne connectée aux grilles de contrôle des transistors à grille flottante du mot,
- les grilles des transistors de contrôle de grille (CGT(i,k)) des mots mémoire (20) appartenant à une même colonne (C(k)) sont connectées à une ligne de sélection de colonne (CSL(k)) commune, et
- les premières bornes des transistors de contrôle de grille des mots mémoire (20) appartenant à une même ligne (R(i)) sont reliées à une ligne de contrôle de grille commune (CGL(i)) qui est parallèle à la ligne de mot (WL(i)) de la ligne (R(i)).

5. Procédé selon la revendication 4, comprenant une étape de connexion des secondes bornes des transistors à grille flottante de chaque colonne (C1(k)) à une ligne de contrôle (SL(k)) commune à tous les transistors à grille flottante (FGT) de la colonne.

6. Mémoire effaçable et programmable électriquement comprenant :
- des cellules mémoire (10) comprenant chacune un transistor de sélection (ST) connecté à un transistor à grille flottante (FGT), chaque transistor comprenant une grille, une première borne de conduction et une seconde borne de conduction, et
- des moyens pour appliquer simultanément une haute tension de programmation ou d'effacement (Vpp2) à au moins une cellule mémoire devant être programmée ou devant être effacée et à une borne d'au moins un transistor ne participant pas au processus de programmation ou d'effacement,
**caractérisé en ce qu'**elle comprend des moyens pour :
- appliquer une tension de compensation (Vc) non nulle à la grille du transistor de selection ne participant pas au processus de programmation ou d'effacement, de manière à augmenter un seuil de claquage du transistor, et
- appliquer une tension d'inhibition (#Vc)-à la grille ou à une borne d'au moins un transistor à grille flottante (FGT) connecté au transistor ayant son seuil de claquage augmenté, pour inhiber un phénomène de programmation douce ou d'effacement doux du transistor à grille flottante.

7. Mémoire selon la revendication 6, comprenant des moyens de programmation agencés pour :
- appliquer une haute tension de programmation (Vpp2) à la première borne d'au moins un premier transistor de sélection (ST(i,7,k)) appartenant à une cellule mémoire devant être programmée et à la première borne d'au moins un second transistor de sélection (ST(i-2,7,k)) appartenant à une cellule mémoire ne devant pas être programmée,
- appliquer la tension de compensation (Vc) à la grille du second transistor de sélection (ST(i-2,7,k)), de manière à augmenter le seuil de claquage du transistor, et
- appliquer une tension d'inhibition de programmation douce (#Vc) à la grille d'un transistor à grille flottante (FGT(i-2,7,k)) relié au second transistor de sélection.

8. Mémoire selon l'une des revendications 6 et 7, dans laquelle les grilles des transistors de sélection (ST) des cellules mémoire sont connectées à des lignes de mot, les cellules mémoire sont agencées en mots mémoire (20), chaque mot mémoire comprenant un transistor de contrôle de grille (CGT(i,k)) connecté aux grilles de contrôle des transistors à grille flottante (FGT) du mot, et comprenant des moyens d'effacement de cellules mémoire agencés pour :
- appliquer une haute tension d'effacement (Vpp2) à la première borne d'au moins un premier transistor de contrôle de grille (CGT(i,k)) d'un premier mot mémoire (20) devant être effacé et à la première borne d'au moins un second transistor de contrôle de grille (CGT(i,k+1)) d'un second mot mémoire (22) ne devant pas être effacé,
- appliquer la tension de compensation (Vc) à la grille du second transistor de contrôle de grille (CGT(i,k+1)), de manière à augmenter le seuil de claquage du transistor, et
- appliquer une tension d'inhibition d'effacement doux (#Vc) à des bornes des transistors à grille flottante (FGT) du second mot mémoire.

9. Mémoire selon l'une des revendications 6 à 8, dans laquelle les cellules mémoire sont agencées dans un plan mémoire présentant les caractéristiques structurelles suivantes :
- les cellules mémoire sont agencées selon des lignes (R(i)),
- les grilles des transistors de sélection (ST) des cellules mémoire d'une même ligne (R(i)) sont connectées à une ligne de mot (WL(i)) commune,
- les premières bornes des transistors de sélection (ST) des cellules mémoire sont reliées à des lignes de bit (BL(j,k)) transversales aux lignes de mot (wL(i)),
- les lignes de bit sont regroupées en colonnes (C(k)),
- les cellules mémoire d'une même colonne (C(k)) et d'une même ligne (R(i)) forment un mot mémoire (20),
- chaque mot mémoire comprend un transistor de contrôle de grille (CGT(i,k)) ayant sa première borne connectée aux grilles de contrôle des transistors à grille flottante du mot,
- les grilles des transistors de contrôle de grille (CGT(i,k)) des mots mémoire (20) appartenant à une même colonne (C(k)) sont connectées à une ligne de sélection de colonne (CSL(k)) commune, et
- les premières bornes des transistors de contrôle de grille des mots mémoire (20) appartenant à une même ligne (R(i)) sont reliées à une ligne de contrôle de grille commune (CGL(i)) qui est parallèle à la ligne de mot (WL(i)) de la ligne (R(i)).

10. Mémoire selon la revendication 9, dans laquelle les secondes bornes des transistors à grille flottante de chaque colonne (C1(k)) sont connectées à une ligne de contrôle (SL(k)) commune à tous les transistors à grille flottante (FGT) de la colonne.

## Claims

1. A method for programming or erasing memory cells (10) each comprising a selection transistor (ST) connected to a floating-gate transistor (FGT), each transistor comprising a gate, a first conduction terminal and a second conduction terminal,
method comprising a step of simultaneously applying a high programming or erase voltage to at least one memory cell that must be programmed or that must be erased and to a terminal of at least one transistor not involved in the programming or erasing process,
**characterized in that** it comprises the steps of:
- applying a non-zero compensation voltage (Vc) to the gate of the selection transistor not involved in the programming or erasing process, so as to increase a breakdown threshold of the transistor, and
- applying an inhibition voltage (#Vc) to the gate or to a terminal of at least one floating-gate transistor (FGT) connected to the transistor having its breakdown threshold increased, to inhibit a phenomenon of soft programming or soft erase of the floating-gate transistor.

2. Method according to claim 1, wherein a step of programming comprises the steps of:
- applying a high programming voltage (Vpp2) to the first terminal of at least one first selection transistor (ST(i,7,k)) belonging to a memory cell that must be programmed and to the first terminal of at least one second selection transistor (ST(i-2,7,k)) belonging to a memory cell that must not be programmed,
- applying the compensation voltage (Vc) to the gate of the second selection transistor (ST(i-2,7,k)), so as to increase the breakdown threshold of the transistor, and
- applying a soft programming inhibition voltage (#Vc) to the gate of a floating-gate transistor (FGT(i-2,7,k)) linked to the second selection transistor.

3. Method according to one of claims 1 and 2, applied to a memory in which the memory cells are arranged in memory words (20), each memory word comprising a control gate transistor (CGT(i,k)) connected to the control gates of the floating-gate transistors of the word, and wherein a step of erasing comprises the steps of:
- applying a high erase voltage (Vpp2) to the first terminal of at least one first control gate transistor (CGT(i,k)) of a first memory word (20) that must be erased and to the first terminal of at least one second control gate transistor (CGT(i,k+1)) of a second memory word (22) that must not be erased,
- applying the compensation voltage (Vc) to the gate of the second control gate transistor (CGT(i,k+1)), so as to increase the breakdown threshold of the transistor, and
- applying a soft erase inhibition voltage (#Vc) to terminals of the floating-gate transistors (FGT) of the second memory word.

4. Method according to one of claims 1 to 3, comprising a step of arranging the memory cells to form a memory array having the following characteristics:
- the memory cells are arranged according to rows (R(i)),
- the gates of the selection transistors (ST) of the memory cells of a same row (R(i)) are connected to a common word line (WL(i)),
- the first terminals of the selection transistors (ST) of the memory cells are linked to bit lines (BL(j,k)) transversal to the word lines (WL(i)),
- the bit lines are grouped together into columns (C(k)),
- the memory cells of a same column (C(k)) and of a same row (R(i)) form a memory word (20),
- each memory word comprises a control gate transistor (CGT(i,k)) having its first terminal connected to the control gates of the floating-gate transistors of the word,
- the gates of the control gate transistors (CGT(i,k)) of the memory words (20) belonging to a same column (C(k)) are connected to a common column selection line (CSL(k)), and
- the first terminals of the control gate transistors of the memory words (20) belonging to a same row (R(i)) are linked to a common control gate line (CGL(i)) that is parallel to the word line (WL(i)) of the row (R(i)).

5. Method according to claim 4, comprising a step of connecting the second terminals of the floating-gate transistors of each column (Cl(k)) to a control line (SL(k)) common to all the floating-gate transistors (FGT) of the column.

6. An electrically erasable and programmable memory comprising:
- memory cells (10) each comprising a selection transistor (ST) connected to a floating-gate transistor (FGT), each transistor comprising a gate, a first conduction terminal and a second conduction terminal, and
- means for simultaneously applying a high programming or erase voltage (Vpp2) to at least one memory cell that must be programmed or that must be erased and to a terminal of at least one transistor not involved in the programming or erasing process,
**characterized in that** it comprises means for:
- applying a non-zero compensation voltage (Vc) to the gate of the selection transistor not involved in the programming or erasing process, so as to increase a breakdown threshold of the transistor, and
- applying an inhibition voltage (#Vc) to the gate or to a terminal of at least one floating-gate transistor (FGT) connected to the transistor having its breakdown threshold increased, to inhibit a phenomenon of soft programming or soft erase of the floating-gate transistor.

7. Memory according to claim 6, comprising programming means arranged for:
- applying a high programming voltage (Vpp2) to the first terminal of at least one first selection transistor (ST(i,7,k)) belonging to a memory cell that must be programmed and to the first terminal of at least one second selection transistor (ST(i-2,7,k)) belonging to a memory cell that must not be programmed,
- applying the compensation voltage (Vc) to the gate of the second selection transistor (ST(i-2,7,k)), so as to increase the breakdown threshold of the transistor, and
- applying a soft programming inhibition voltage (#Vc) to the gate of a floating-gate transistor (FGT(i-2,7,k)) linked to the second selection transistor.

8. Memory according to one of claims 6 and 7, wherein the gates of the selection transistors (ST) of the memory cells are connected to word lines, the memory cells are arranged in memory words (20), each memory word comprising a control gate transistor (CGT(i,k)) connected to the control gates of the floating-gate transistors (FGT) of the word, and comprising means for erasing memory cells arranged for:
- applying a high erase voltage (Vpp2) to the first terminal of at least one first control gate transistor (CGT(i,k)) of a first memory word (20) that must be erased and to the first terminal of at least one second control gate transistor (CGT(i,k+1)) of a second memory word (22) that must not be erased,
- applying the compensation voltage (Vc) to the gate of the second control gate transistor (CGT(i,k+1)), so as to increase the breakdown threshold of the transistor, and
- applying a soft erase inhibition voltage (#Vc) to terminals of the floating-gate transistors (FGT) of the second memory word.

9. Memory according to one of claims 6 to 8, wherein the memory cells are arranged in a memory array having the following structural characteristics:
- the memory cells are arranged according to rows (R(i)),
- the gates of the selection transistors (ST) of the memory cells of a same row (R(i)) are connected to a common word line (WL(i)),
- the first terminals of the selection transistors (ST) of the memory cells are linked to bit lines (BL(j,k)) transversal to the word lines (WL(i)),
- the bit lines are grouped together into columns (C(k)),
- the memory cells of a same column (C(k)) and of a same row (R(i)) form a memory word (20),
- each memory word comprises a control gate transistor (CGT(i,k)) having its first terminal connected to the control gates of the floating-gate transistors of the word,
- the gates of the control gate transistors (CGT(i,k)) of the memory words (20) belonging to a same column (C(k)) are connected to a common column selection line (CSL(k)), and
- the first terminals of the control gate transistors of the memory words (20) belonging to a same row (R(i)) are linked to a common control gate line (CGL(i)) that is parallel to the word line (WL(i)) of the row (R(i)).

10. Memory according to claim 9, wherein the second terminals of the floating-gate transistors of each column (Cl(k)) are connected to a control line (SL(k)) common to all the floating-gate transistors (FGT) of the column.

## Patentansprüche

1. Verfahren zur Programmierung oder zum Löschen von Speicherzellen (10), von denen jede einen Auswahltransistor (ST) umfasst, der an einen Floating-Gate-Transistor (FGT) angeschlossen ist, wobei jeder Transistor ein Gate, einen ersten Leitanschluss und einen zweiten Leitanschluss umfasst,
wobei das Verfahren einen Schritt zum simultanen Anlegen einer hohen Programmier- oder Löschspannung an wenigstens eine zu programmierende oder zu löschende Speicherzelle und an einen Anschluss von wenigstens einem nicht an dem Programmier- oder Löschvorgang beteiligten Transistor umfasst,
**dadurch gekennzeichnet, dass** es folgende Schritte umfasst:
- Anlegen einer Kompensationsspannung (Vc) von ungleich Null an das Gate des nicht an dem Programmier- oder Löschvorgang beteiligten Auswahltransistors zum Erhöhen einer Durchbruchschwelle des Transistors, und
- Anlegen einer Hemmungsspannung (#Vc) an das Gate oder an einen Anschluss von wenigstens einem Floating-Gate-Transistor (FGT), der an den Transistor angeschlossenen ist, dessen Durchbruchschwelle erhöht ist, zur Hemmung eines weichen Programmier- oder Löschvorgangs des Floating-Gate-Transistors.

2. Verfahren nach Anspruch 1, bei dem ein Programmierschritt folgende Schritte umfasst:
- Anlegen einer hohen Programmierspannung (Vpp2) an den ersten Anschluss von wenigstens einem ersten, zu einer zu programmierenden Speicherzelle gehörenden Auswahltransistor (ST(i,7,k)) und an den ersten Anschluss von wenigstens einem zweiten, zu einer nicht zu programmierenden Speicherzelle gehörenden Auswahltransistor (ST(i-2,7,k)),
- Anlegen der Kompensationsspannung (Vc) an das Gate des zweiten Auswahltransistors (ST(i-2,7,k)), zum Erhöhen der Durchbruchschwelle des Transistors, und
- Anlegen einer Spannung (#Vc) zur Hemmung einer weichen Programmierung an das Gate eines an den zweiten Auswahltransistor angeschlossenen Floating-Gate-Transistors (FGT(i-2,7,k)).

3. Verfahren nach einem der Ansprüche 1 und 2, das bei einem Speicher angewendet wird, in dem die Speicherzellen zu Speicherwörtern (20) angeordnet sind, wobei jedes Speicherwort einen Gate-Steuer-Transistor (CGT(i,k)) umfasst, der an die Steuer-Gates der Floating-Gate-Transistoren für das Wort angeschlossen ist, und bei dem ein Löschschritt folgende Schritte umfasst:
- Anlegen einer hohen Löschspannung (Vpp2) an den ersten Anschluss von wenigstens einem ersten Gate-Steuer-Transistor (CGT(i,k)) eines ersten zu löschenden Speicherworts (20) und an den ersten Anschluss von wenigstens einem zweiten Gate-Steuer-Transistor (CGT(i,k+1)) eines zweiten, nicht zu löschenden Speicherworts (22),
- Anlegen der Kompensationsspannung (Vc) an das Gate des zweiten Gate-Steuer-Transistors (CGT(i,k+1)), zum Erhöhen der Durchbruchschwelle des Transistors, und
- Anlegen einer Spannung (#Vc) zur Hemmung eines weichen Löschvorgangs an Anschlüsse der Floating-Gate-Transistoren (FGT) des zweiten Speicherworts.

4. Verfahren nach einem der Ansprüche 1 bis 3, umfassend einen Schritt zur Anordnung der Speicherzellen, der zur Bildung einer Speicherebene mit den folgenden Merkmalen führt:
- die Speicherzellen sind in Zeilen (R(i)) angeordnet,
- die Gates der Auswahltransistoren (ST) der Speicherzellen einer selben Zeile (R(i)) sind an eine gemeinsame Wortleitung (WL(i)) angeschlossen,
- die ersten Anschlüsse der Auswahltransistoren (ST) der Speicherzellen sind an quer zu den Wortleitungen (WL(i)) angeordnete Bitleitungen (BL(j,k)) angeschlossen,
- die Bitleitungen sind zu Spalten (C(k)) zusammengefasst,
- die Speicherzellen einer selben Spalte (C(k)) und einer selben Zeile (R(i)) bilden ein Speicherwort (20),
- jedes Speicherwort umfasst einen Gate-Steuer-Transistor (CGT(i,k)), dessen erster Anschluss an die Steuer-Gates der Floating-Gate-Transistoren für das Wort angeschlossen ist,
- die Gates der Gate-Steuer-Transistoren (CGT(i,k)) der zu einer selben Spalte (C(k)) gehörenden Speicherwörter (20) sind an eine gemeinsame Spaltenselektionsleitung (CSL(k)) angeschlossen, und
- die ersten Anschlüsse der Gate-Steuer-Transistoren der zu einer selben Zeile (R(i)) gehörenden Speicherwörter (20) sind an eine gemeinsame Gate-Steuer-Leitung (CGL(i)) angeschlossen, welche parallel zur Wortleitung (WL(i)) der Zeile (R(i)) verläuft.

5. Verfahren nach Anspruch 4, umfassend einen Schritt zum Anschluss der zweiten Anschlüsse der Floating-Gate-Transistoren jeder Spalte (Cl(k)) an eine Steuer-Leitung (SL(k)), welche allen Floating-Gate-Transistoren (FGT) der Spalte gemeinsam ist.

6. Elektrisch löschbarer und programmierbarer Speicher, umfassend:
- Speicherzellen (10), von denen jede einen Auswahltransistor (ST) umfasst, der an einen Floating-Gate-Transistor (FGT) angeschlossen ist, wobei jeder Transistor ein Gate, einen ersten Leitanschluss und einen zweiten Leitanschluss umfasst, und
- Mitteln zum simultanen Anlegen einer hohen Programmier- oder Löschspannung (Vpp2) an wenigstens eine zu programmierende oder zu löschende Speicherzelle und an einen Anschluss von wenigstens einem nicht an dem Programmier- oder Löschvorgang beteiligten Transistor, **dadurch gekennzeichnet, dass** dieser Mittel umfasst zum:
- Anlegen einer Kompensationsspannung (Vc) von ungleich Null an das Gate des nicht an dem Programmier- oder Löschvorgang beteiligten Auswahltransistors, zum Erhöhen einer Durchbruchschwelle des Transistors, und
- Anlegen einer Hemmungsspannung (#Vc) an das Gate oder an einen Anschluss von wenigstens einem Floating-Gate-Transistor (FGT), der an den Transistor angeschlossenen ist, dessen Durchbruchschwelle erhöht ist, zur Hemmung eines weichen Programmier- oder Löschvorgangs des Floating-Gate-Transistors.

7. Speicher nach Anspruch 6, umfassend Programmiermittel, welche für folgendes angeordnet sind:
- Anlegen einer hohen Programmierspannung (Vpp2) an den ersten Anschluss von wenigstens einem ersten, zu einer zu programmierenden Speicherzelle gehörenden Auswahltransistor (ST(i,7,k)) und an den ersten Anschluss von wenigstens einem zweiten, zu einer nicht zu programmierenden Speicherzelle gehörenden Auswahltransistor (ST(i-2,7,k)),
- Anlegen der Kompensationsspannung (Vc) an das Gate des zweiten Auswahltransistors (ST(i-2,7,k)), zum Erhöhen der Durchbruchschwelle des Transistors, und
- Anlegen einer Spannung (#Vc) zur Hemmung einer weichen Programmierung an das Gate eines an den zweiten Auswahltransistor angeschlossenen Floating-Gate-Transistors (FGT(i-2,7,k)).

8. Speicher nach einem der Ansprüche 6 und 7, bei dem die Gates der Auswahltransistoren (ST) der Speicherzellen an Wortleitungen angeschlossen sind, die Speicherzellen zu Speicherwörtern (20) angeordnet sind, wobei jedes Speicherwort einen Gate-Steuer-Transistor (CGT(i,k)) umfasst, der an die Steuer-Gates der Floating-Gate-Transistoren (FGT) für das Wort angeschlossen ist, und umfassend Mittel zum Löschen von Speicherzellen, welche angeordnet sind für ein:
- Anlegen einer hohen Löschspannung (Vpp2) an den ersten Anschluss von wenigstens einem ersten Gate-Steuer-Transistor (CGT(i,k)) eines ersten zu löschenden Speicherworts (20) und an den ersten Anschluss von wenigstens einem zweiten Gate-Steuer-Transistor (CGT(i,k+1)) eines zweiten, nicht zu löschenden Speicherworts (22),
- Anlegen der Kompensationsspannung (Vc) an das Gate des zweiten Gate-Steuer-Transistors (CGT(i,k+1)), zum Erhöhen der Durchbruchschwelle des Transistors, und
- Anlegen einer Spannung (#Vc) zur Hemmung eines weichen Löschvorgangs an Anschlüsse der Floating-Gate-Transistoren (FGT) des zweiten Speicherworts.

9. Speicher nach einem der Ansprüche 6 bis 8, **dadurch gekennzeichnet, dass** die Speicherzellen zu einer Speicherebene angeordnet sind, welche folgende strukturellen Merkmale aufweist:
- die Speicherzellen sind in Zeilen (R(i)) angeordnet,
- die Gates der Auswahltransistoren (ST) der Speicherzellen einer selben Zeile (R(i)) sind an eine gemeinsame Wortleitung (WL(i)) angeschlossen,
- die ersten Anschlüsse der Auswahltransistoren (ST) der Speicherzellen sind an quer zu den Wortleitungen (WL(i)) angeordneten Bitleitungen (BL(j,k)) angeschlossen,
- die Bitleitungen sind zu Spalten (C(k)) zusammengefasst,
- die Speicherzellen einer selben Spalte (C(k)) und einer selben Zeile (R(i)) bilden ein Speicherwort (20),
- jedes Speicherwort umfasst einen Gate-Steuer-Transistor (CGT(i,k)), dessen erster Anschluss an die Steuer-Gates der Floating-Gate-Transistoren für das Wort angeschlossen ist,
- die Gates der Gate-Steuer-Transistoren (CGT(i,k)) der zu einer selben Spalte (C(k)) gehörenden Speicherwörter (20) sind an eine gemeinsame Spaltenselektionsleitung (CSL(k)) angeschlossen, und
- die ersten Anschlüsse der Gate-Steuer-Transistoren der zu einer selben Zeile (R(i)) gehörenden Speicherwörter (20) sind an eine gemeinsame Gate-Steuer-Leitung (CGL(i)) angeschlossen, welche parallel zur Wortleitung (WL(i)) der Zeile (R(i)) verläuft.

10. Speicher nach Anspruch 9, **dadurch gekennzeichnet, dass** die zweiten Anschlüsse der Floating-Gate-Transistoren jeder Spalte (Cl(k)) an eine Steuer-Leitung (SL(k)) angeschlossen sind, welche allen Floating-Gate-Transistoren (FGT) der Spalte gemeinsam ist.
